# EUROPÄISCHE PATENTSCHRIFT

(11) **EP 0 863 593 B1**
(45) Veröffentlichungstag und Bekanntmachung des Hinweises auf die Patenterteilung: **29.08.2001**
(21) Anmeldenummer: 98102656.0
(22) Anmeldetag: 17.02.1998
(51) Int. Cl.: H02B 1/28, H05K 7/18, H02B 1/56

(54) **Freiluftgehäuse**
Outdoor cabinet
Armoire d'extérieur

(30) Priorität: 07.03.1997 DE 19709460
(43) Veröffentlichungstag der Anmeldung: 09.09.1998
(73) Patentinhaber: KRONE GmbH, 14167 Berlin (DE)
(72) Erfinder: Sielaff, Michael, Dipl.-Ing., 12105 Berlin (DE); Czogalla, Frank, Dipl.-Ing., 12205 Berlin (DE)

(56) Entgegenhaltungen:
- DE-A- 1 947 399
- DE-A- 2 357 633
- DE-A- 19 545 448
- GB-A- 1 418 159

## Beschreibung

Die Erfindung betrifft ein Freiluftgehäuse zur Aufnahme von Elektronik, insbesondere von Komponenten der Telekommunikations- und Datentechnik, wobei die Elektronik von einer ersten Gehäusestruktur hermetisch dicht eingeschlossen ist, und eine zweite äußere Gehäusestruktur derart an der ersten inneren Gehäusestruktur angeordnet ist, daß sich zwischen den Gehäusestrukturen ein Hohlraum bildet.

Dokument DE 19 47 339 A beschreibt ein Gehäuse zur Aufnahme von Elektronik, wobei das Gehäuse Wände aufweist, die aus zwei Sandwichplatten bestehen, mit einem zwischen den Platten angeordneten Stützprofil. Zwischen den zwei Sandwichplatten wird ein Hohlraum gebildet, in welchem Kühlluft strömen kann.

Bekannte Freiluftgehäuse zur Aufnahme von Elektronik können hermetisch dicht ausgebildet sein, um die im Inneren befindliche Elektronik vor störender elektromagnetischen Strahlung und anderen Umwelteinflüssen, wie z.B. Regen, zu schützen. Allerdings erzeugt die im Inneren des Freiluftgehäuses angeordnete Elektronik eine elektrische Verlustleistung, die in Form von Wärme abgegeben wird. Diese Wärme wiederum hat negative Auswirkungen auf die Funktion der Elektronik und muß daher trotz der hermetischen Gehäusestruktur irgendwie geartet abgeführt werden. Dazu sind aus dem Stand der Technik zwei Alternativlösungen bekannt. Zum einen werden doppelwandige Gehäuse verwendet und zum anderen wird ein zweites äußeres Gehäuse derart um das innere Gehäuse angeordnet, so daß sich zwischen den Gehäusestrukturen ein Hohlraum bildet. Beiden Lösungen gemeinsam ist das Prinzip der Wärmeabfuhr. Die durch den Hohlraum strömende Luft nimmt einen Teil der Wärme auf und steigt nach oben (Kamineffekt). Dort kann die erwärmte Luft über Luftschächte oder -spalte abgeführt werden. Bei Erwärmung von außen, z.B. durch direkte Sonneneinstrahlung, wirkt die Luftschicht darüber hinaus als Wärmeisolator. Nachteilig an den bekannten Freiluftgehäusen ist deren mangelnde Flexibilität auf verschiedene äußere Rahmenbedingungen. So ist es z.B. bei Beschädigung oder Zerstörung der äußeren Gehäusestruktur notwendig, diese ganz oder teilweise zu ersetzen. Ebenso ist es aufgrund der ständigen Erhöhungen der Übertragungskapazitäten notwendig, neue Freiluftgehäuse zu installieren oder bestehende Gehäuse zu erweitern. Reparatur, Umrüstung oder Neuinstallation haben zur Folge, daß die bisher verwendeten inneren und äußeren Gehäusestrukturen oder aber die verwendeten doppelwandigen Gehäuse aufgrund ihrer Beschädigungen oder ihren geometrischen Abmessungen nicht wiederverwendet werden können. Zum anderen ist man heutzutage bemüht, im Stadtgebiet ein harmonisches Gesamtlandschaftsbild zu erzeugen. Ein störender Faktor bleiben die farblich z.T. völlig unpassenden Freiluftgehäuse. Wird nun aber z.B. beim Neubau einer Siedlung die farbliche Gestaltung der Freiluftgehäuse an die verwendete Fassadenfarbe angepaßt, so stellt sich das Problem spätestens bei der nächsten Fassadenrenovierung.

Der Erfindung liegt daher das technische Problem zugrunde, ein Freiluftgehäuse zu schaffen, das bei gleichbleibenden technischen Eigenschaften einfach zu reparieren und an verschiedene oder sich ändernde äußere Rahmenbedingungen angepaßt werden kann.

Die Lösung des technischen Problems ergibt sich durch die Merkmale des Patentanspruchs 1. Durch die Ausbildung der äußeren Gehäusestruktur als Hohlprofilschienen, die an der ersten inneren Gehäusestruktur lösbar befestigt sind, bildet sich wie beim Stand der Technik zwischen den Gehäusestrukturen ein Hohlraum, durch den auftretende Verlustwärme abgeführt werden kann. Gleichzeitig kann das aufgebaute Freiluftgehäuse leicht repariert und flexibel an sich ändernde Rahmenbedingungen angepaßt werden. Bei Umbau oder Erweiterung eines bereits existierenden Freiluftgehäuses können die verwendeten Hohlprofilschienen wiederverwendet werden, und es werden einfach zusätzliche Hohlprofilschienen an dem neuen inneren Gehäuse angeordnet. Durch Verwendung farbiger Hohlprofilschienen können sehr einfach beliebige Farbgestaltungen erzeugt werden. Außerdem vereinfacht sich die Montage des Freiluftgehäuses, da die Hohlprofilschienen im Gegensatz zu den bisher verwendeten sperrigen Gehäusestrukturen einfacher handhabbar sind. Weitere vorteilhafte Ausgestaltungen der Erfindung ergeben sich aus den Unteransprüchen.

Durch die Anwendung der Befestigungsmittel der Hohlprofilschienen derart, daß diese im eingebauten Zustand nicht von außen zugänglich sind, wird Manipulationen und Vandalismus vorgebeugt. Als Befestigungsmittel kommen alle bekannten Befestigungsarten in frage, wobei vorzugsweise die Hohlprofilschienen an der inneren Gehäusestruktur eingehängt werden, so daß die äußere Oberflächen der Hohlprofilschienen keinen Aufschluß auf die Befestigung bieten. In einer bevorzugten Ausführungsform sind die Hohlprofilschienen als Zwillingsrechteck-Hohlprofile ausgebildet, die gegenüber herkömmlichen Hohlprofilschienen eine besonders hohe Festigkeit aufweisen. Weiter können die Hohlprofilschienen mit einer Aufnahme für Informationsträger, wie z.B. Werbung, Fahrpläne oder öffentliche Bekanntmachungen, ausgebildet sein, oder aber selbst als Informationsträger ausgebildet sein. So kann z.B. das Gehäuse als Werbeträger genutzt werden. Aus Gründen des Deigns oder der Technik können die Hohlprofilschienen jede beliebige Form haben.

Die Erfindung wir nachfolgend anhand eines bevorzugten Ausführungsbeispieles näher erläutert. Die Figuren zeigen:
- Fig. 1: eine Perspektivdarstellung eines modular aufgebauten Freiluftgehäuses,
- Fig. 2: eine Detailansicht von Fig. 1,
- Fig. 3: eine Draufsicht auf das Freiluftgehäuse,
- Fig. 4: eine Detailansicht von Fig. 3 und
- Fig. 5: eine Draufsicht auf eine Hohlprofilschiene.

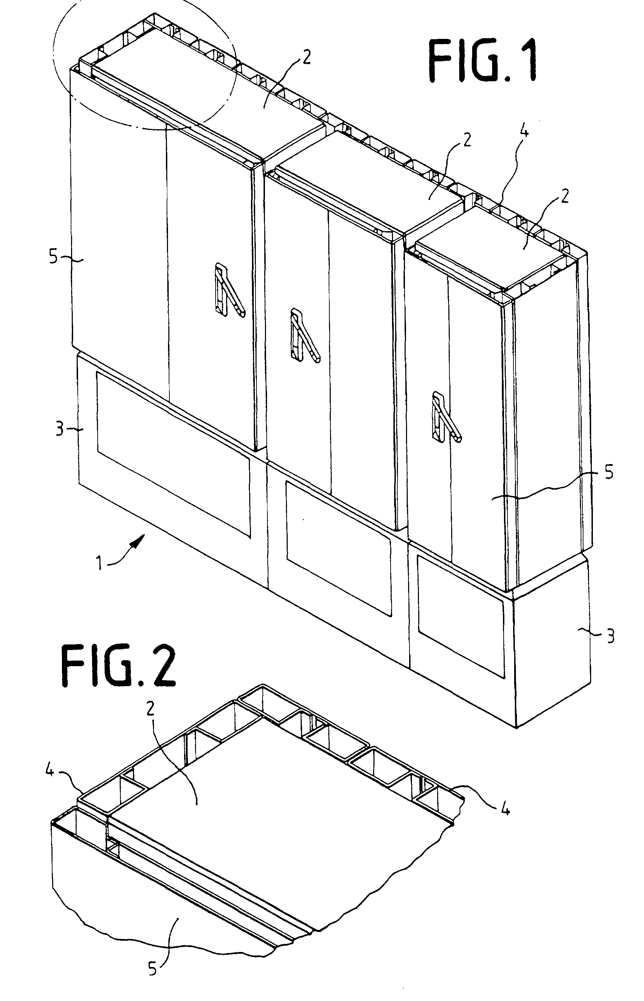

In der Fig. 1 ist perspektivisch ein Freiluftgehäuse 1 dargestellt. Das Freiluftgehäuse 1 umfaßt drei Module, die jeweils ein eigenes inneres Gehäuse 2 aufweisen. Der die elektrischen Komponenten enthaltene Bereich ist oberhalb eines Sockels 3 angeordnet, wobei vorzugsweise jedem Modul sein eigener Sockel 3 zugeordnet ist und um die Sockel eine einteilige Sockelverbindung angeordnet ist. Die einzelnen Module sind über aus Hohlprofilschienen 4 bestehende Türen 5 von außen separat zugänglich. Zur Übersicht ist das Freiluftgehäuse 1 ohne Dach dargestellt. Wie besonders aus Fig. 2 ersichtlich ist, sind die Hohlprofilschienen 4 auf Stoß zu den inneren Gehäusen 2 angeordnet und an diesen befestigt, wobei die Türen 5 mittels Scharnieren 6 an benachbarten Hohlprofilschienen 4 oder am inneren Gehäuse 2 angelenkt sind. Zwischen den inneren Gehäusen 2, die jeweils hermetisch dicht sind, und den die äußere Gehäusestruktur bildenden Hohlprofilschienen 4 bildet sich ein Hohlraum. Die in den inneren Gehäusen 2 erzeugte Verlustwärme der elektrischen Komponenten wird über die Außenwände der inneren Gehäuse 2 auf die sich im Hohlraum befindliche Luft übertragen. Die erwärmte Luft steigt nach oben und kann über Luftschächte oder Luftspalte zwischen den Wänden und dem Dach den Hohlraum verlassen, so daß die erzeugte Verlustwärme abgeführt wird.

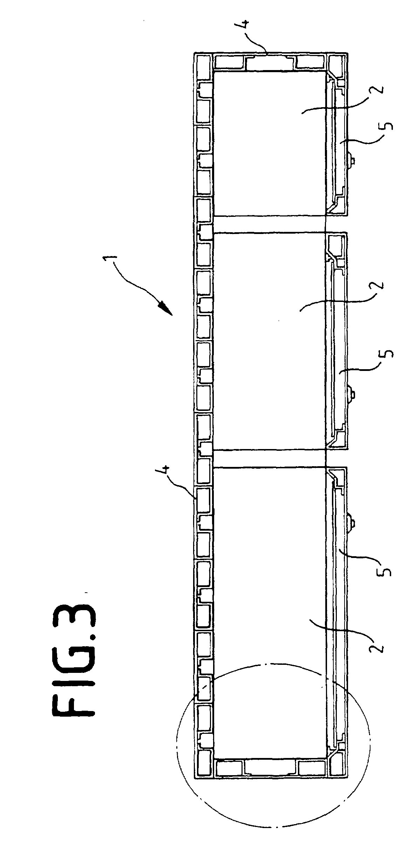

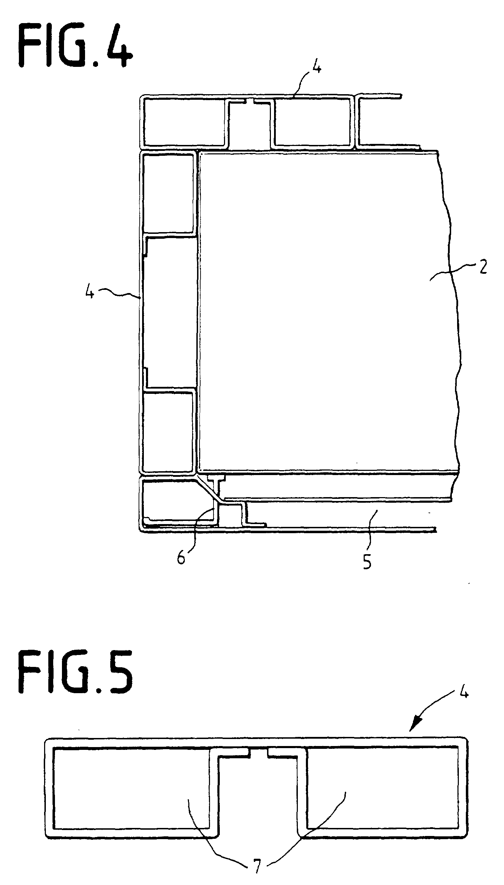

In der Fig. 3 ist das Freiluftgehäuse 1 ohne Dach in einer Draufsicht und in Fig. 4 eine Detailansicht der Fig. 3 dargestellt. Das Scharnier 6 wird an dem jeweiligen inneren Gehäuse 2 befestgt und durch eine Hohlprofilschiene 4 geführt.

Fig. 5 zeigt eine Draufsicht auf eine bevorzugte Ausführungsform der Hohlprofilschiene 4 als Zwillingsrechteck-Hohlprofil, die der äußeren Gehäusestruktur eine besondere Festigkeit verleihen, wobei die Rechtecke 7 unterschiedliche geometrische Abmessungen aufweisen können.

## Patentansprüche

1. Freiluftgehäuse zur Aufnahme von Elektronik, insbesondere von Komponenten der Telekommunikation- und Datentechnik, wobei die Elektronik von einer ersten inneren Gehäusestruktur hermetisch dicht umschlossen ist, und eine zweite äußere Gehäusestruktur derart an der ersten inneren Gehäusestruktur angeordnet ist, daß sich zwischen den Gehäusestrukturen ein Hohlraum bildet, wobei die zweite äußere Gehäusestruktur durch Hohlprofilschienen (4) gebildet ist, die an der ersten inneren Gehäusestruktur (2) lösbar befestigt sind.

2. Freiluftgehäuse nach Anspruch 1, **dadurch gekennzeichnet**, daß mindestens Wände, Tür (5) und Dach aus separaten Hohlprofilschienen (4) gebildet sind.

3. Freiluftgehäuse nach Anspruch 1 oder 2, **dadurch gekennzeichnet**, daß die Befestigungsmittel der äußeren Gehäusestruktur im montierten Zustand nicht von außen zugänglich angeordnet sind.

4. Freiluftgehäuse nach einem der Ansprüche 1 bis 3, **dadurch gekennzeichnet**, daß die Hohlprofilschienen (4) als Zwillingsrechteck-Hohlprofil ausgebildet sind.

5. Freiluftgehäuse nach einem der vorangegangenen Ansprüche, **dadurch gekennzeichnet**, daß die Hohlprofilschienen (4) mit Aufnahmen für Informationsträger oder selbst als Informationsträger ausgebildet sind.

6. Verwendung einer Hohlprofilschiene zur Bildung einer äußerem Gehäusestruktur eines Freiluftgehäuses (1) nach einem der Ansprüche 1 bis 5.

## Claims

1. Outdoor housing for accommodating electronics, in particular components for telecommunications and data technology, the electronics being surrounded in a hermetically sealed manner by a first, inner housing structure, and a second, outer housing structure being arranged on the first, inner housing structure in such a manner that a cavity is formed between the housing structures,
the second, outer housing structure being formed by hollow-section rails (4) which are detachably attached to the first, inner housing structure (2).

2. Outdoor housing according to Claim 1, **characterized in that** at least walls, a door (5) and a roof are formed from separate hollow-section rails (4).

3. Outdoor housing according to Claim 1 or 2, **characterized in that** the attachment means for the outer housing structure are not accessible from the outside in the assembled state.

4. Outdoor housing according to one of Claims 1 to 3, **characterized in that** the hollow-section rails (4) are designed as a twin rectangular hollow section.

5. Outdoor housing according to one of the preceding claims, **characterized in that** the hollow-section rails (4) are designed with holders for information media or are themselves designed as information media.

6. Use of a hollow-section rail according to one of Claims 1 to 5 for forming an outer housing structure of an outdoor housing (1).

## Revendications

1. Armoire d'extérieur pour recevoir des éléments électroniques, en particulier des composants de la technique des télécommunications et des données, dans laquelle les éléments électroniques sont entourés de manière hermétiquement scellée par une première structure d'armoire interne, et une deuxième structure d'armoire externe est disposée de telle sorte sur la première structure d'armoire interne, qu'il se forme entre les structures d'armoire un espace creux,
la deuxième structure d'armoire externe étant formée par des rails profilés creux (4) qui sont fixés de manière détachable sur la première structure d'armoire interne (2).

2. Armoire d'extérieur selon la revendication 1, **caractérisée en ce qu**'au moins des parois, une porte (5) et un toit sont formés à partir de rails profilés creux séparés (4).

3. Armoire d'extérieur selon la revendication 1 ou 2, **caractérisée en ce que** les moyens de fixation de la structure d'armoire externe ne sont pas accessibles de l'extérieur dans l'état monté.

4. Armoire d'extérieur selon l'une quelconque des revendications 1 à 3, **caractérisée en ce que** les rails profilés creux (4) sont formés en tant que profil creux rectangulaire double.

5. Armoire d'extérieur selon l'une quelconque des revendications précédentes, **caractérisée en ce que** les rails profilés creux (4) sont formés avec des évidements pour des supports d'information ou eux-mêmes en tant que supports d'information.

6. Utilisation d'un rail profilé creux selon l'une quelconque des revendications 1 à 5, pour la formation d'une structure d'armoire externe d'une armoire d'extérieur (1).
